# FASCICULE DE BREVET EUROPEEN

(11) **EP 4 331 327 B1**
(45) Date de publication et mention de la délivrance du brevet: **09.04.2025**
(21) Numéro de dépôt: 22723145.3
(22) Date de dépôt: 27.04.2022
(51) Int. Cl.: H05K 7/14

(54) **ENSEMBLE ÉLECTRONIQUE MODULAIRE**
MODULARE ELEKTRONISCHE ANORDNUNG
MODULAR ELECTRONIC ASSEMBLY

(30) Priorité: 28.04.2021 FR 2104432
(43) Date de publication de la demande: 06.03.2024
(73) Titulaire: Openindus, 31300 Toulouse (FR)
(72) Inventeur: MORELIERE, David, 31300 Toulouse (FR)
(74) Mandataire: Ipside
(86) Numéro de dépôt international: PCT/EP2022/061191
(87) Numéro de publication internationale: WO 2022/229255

(56) Documents cités:
- EP-A1- 1 595 312
- US-A1- 2004 201 972
- US-A1- 2011 249 399

## Description

### Domaine technique de l'invention

L'invention concerne un ensemble électronique modulaire, communément dénommé automate programmable, pour le contrôle de machines et d'équipements. L'invention est notamment destinée à des applications dans le domaine industriel, ferroviaire, naval, robotique, ou encore des bancs de tests et d'essais.

### Technique antérieure

Les ensembles électroniques modulaires actuels se présentent sous la forme d'une plaque, appelée fond de panier, comportant une pluralité de connecteurs, et sur laquelle viennent se brancher des modules électroniques.

Ces ensembles électroniques sont principalement destinés à être intégrés dans des armoire électriques et présentent des dimensions, notamment en profondeur, qui ne sont pas toujours compatibles avec une utilisation dans des espaces restreints. De plus, les modules électroniques doivent nécessairement être positionnés les uns à côté des autres pour que l'ensemble électronique modulaire fonctionne.

En outre, les modules électroniques sont généralement verrouillés à la plaque fond de panier par vissage. Il s'avère donc nécessaire pour un opérateur d'être muni d'un outil spécifique s'il souhaite retirer ou ajouter un module électronique selon le besoin.

Les ensembles électroniques modulaires actuels se révèlent somme toute peu modulables.

Des exemples d'ensembles électroniques modulaires sont connus des documents US2004201972, US2011249399 et EP1595312.

### Présentation de l'invention

La présente invention vise à remédier aux inconvénients précités. La présente invention est une alternative aux ensembles électroniques modulaires actuels.

A cet effet, il est proposé par la présente invention un ensemble électronique modulaire comportant :
- un rail comportant une embase, allongée selon un axe X, logeant une carte électronique dite bus fond de panier, allongée selon l'axe X, ledit rail définissant une pluralité d'emplacements alignés selon ledit axe X, l'embase comportant, au niveau de chaque emplacement, d'une part une première cavité et d'autre part deux deuxièmes cavités,
   le bus fond de panier comportant, au niveau de chaque emplacement, une rangée de connecteurs femelles,

- une pluralité de modules électronique, dit modules,
   chaque module étant configuré pour être monté dans au moins un emplacement du rail et à y être maintenu fixement de manière réversible dans une position dite opérante, chaque module comportant :
   ∘ un boîtier comportant un fond et un couvercle, le fond comportant au moins un organe de retenue saillant vers l'extérieur dudit boîtier,
   ∘ une carte électronique logée dans le boîtier, comportant au moins une broche de connexion formée d'une rangée de connecteurs males qui s'étendent hors du boîtier via une fenêtre traversante pratiquée dans le fond du boîtier,
   ∘ un organe de verrouillage comportant un levier monté libre en rotation par rapport au fond, ledit levier comportant, au niveau d'une partie proximale, deux crochets.

L'ensemble électronique modulaire est tel que :
- lorsqu'un module est monté dans un emplacement du rail et fixé de position opérante:
   ∘ le fond dudit module est positionné en vis-à-vis du rail,
   ∘ un organe de retenue du fond dudit module est engagé dans la première cavité de l'embase,
   ∘ chaque crochet du levier de l'organe de verrouillage dudit module est engagé respectivement dans une deuxième cavité de l'embase,
   ∘ la rangée de connecteurs males d'une broche de connexion de la carte électronique dudit module est en contact avec la rangée de connecteurs femelles, ou
- lorsqu'un module (50) est monté dans au moins deux emplacements attenants du rail et fixé dans une position opérante :
   ∘ le fond dudit module est positionné en vis-à-vis du rail,
   ∘ un organe de retenue du fond dudit module est engagé dans la première cavité de l'embase, au niveau d'un des au moins deux emplacements,
   ∘ un des crochets du levier de l'organe de verrouillage dudit module est engagé dans une deuxième cavité de l'embase, au niveau d'un des au moins deux emplacements, et l'autre crochet est engagé dans une deuxième cavité de l'embase, au niveau d'un autre des au moins deux emplacements,
   ∘ la rangée de connecteurs males d'une broche de connexion de la carte électronique dudit module est en contact avec une rangée de connecteurs femelles au niveau d'un des au moins deux emplacements.

Le verrouillage d'un module sur le rail se fait, après insertion de l'organe de retenue dans la première cavité de l'embase, par une rotation du levier de l'organe de verrouillage dudit module jusqu'à ce que chaque crochet dudit levier vienne s'engager dans une deuxième cavité de l'embase.

Le module est ainsi maintenu fixement au rail uniquement d'une part via l'organe de retenue et d'autre part par les crochets du levier.

Un tel ensemble électronique modulaire permet avantageusement le montage/démontage du module sur/hors du rail, sans recourir à un outil particulier, en effectuant une rotation du levier de l'organe de verrouillage de sorte à engage/désengager chaque crochet dudit levier dans/hors de la deuxième cavité de l'embase. Un tel ensemble électronique modulaire permet avantageusement de proposer un module dont la carte électronique est préférentiellement réalisée pour conférer audit module, une ou plusieurs fonctionnalités distinctes, telle que par exemple le contrôle de sorties digitales, le contrôle des motorisations, l'analyse des entrées analogiques, la communication cellulaire.

Un tel ensemble électronique modulaire permet avantageusement de proposer des modules présentant des dimensions réduites par rapport au modules existants et en conséquence pouvant être utilisés dans des espaces restreints.

Un tel ensemble électronique modulaire permet avantageusement de proposer des modules dimensionnés et configurés pour être montés sur un ou plusieurs emplacements attenants.

De par la conception électronique du bus fond de panier, un tel ensemble électronique modulaire permet avantageusement de monter sur le rail des modules dans des emplacements attenants ou dans des emplacements distants.

Un tel ensemble électronique modulaire peut être avantageusement configuré pour intégrer directement notamment des modems sans fil, des contrôleurs moteur, des entrées et sortie digitales ou analogiques ou encore des bus de communication. Selon des modes de réalisation particuliers, l'ensemble électronique modulaire selon l'invention répond en outre aux caractéristiques suivantes, mises en œuvre séparément ou en chacune de leurs combinaisons techniquement opérantes. Dans des modes de réalisation préférés, chaque deuxième cavité est :
- agencée à cheval sur deux emplacements voisins attenants du rail,
- dimensionnée pour recevoir deux crochets de deux modules disposés chacun dans un desdits deux emplacements.

Une telle configuration permet avantageusement limiter la perte d'espace entre deux modules attenants.

Dans des modes de réalisation préférés, l'ensemble électronique modulaire est configuré de sorte que :
- au niveau de chaque emplacement du rail, l'embase comporte un trou de réception,
- le fond du boîtier d'un module comporte un plot d'orientation.

Dans une telle configuration, l'ensemble électronique modulaire étant tel que lorsque le module est monté dans au moins un emplacement du rail et fixé dans une position opérante, le plot d'orientation coopère avec un trou de réception de l'embase, au niveau d'emplacement du rail. Un tel plot d'orientation permet avantageusement d'empêcher le positionnement du boîtier du module sur le rail, lorsque ledit boîtier n'est pas positionné sur le rail dans le bon sens.

Dans des modes de réalisation préférés, pour garantir le positionnement de la carte électronique dans le boîtier d'un module, ledit boîtier comporte des éléments de maintien en position de la carte électronique dans le boîtier.

Dans des modes de réalisation préférés, le boîtier d'un module comporte une ouverture traversante pratiquée dans le couvercle pour le passage d'un connecteur secondaire disposé sur la carte électronique du module. Un tel connecteur secondaire est destiné à interagir avec au moins un connecteur de type soit informatique soit industriel, tel que par exemple un connecteur industriel 16 points au pas de de 3,5 mm ou un connecteur micro USB type A/B.

Dans des modes de réalisation préférés, le rail comporte des éléments de clipsage destinés à coopérer avec des éléments de clipsage d'un autre rail. De tels éléments de clipsage permettent, lorsqu'ils coopèrent avec les éléments de clipsage d'un autre rail, un maintien en position du rail parallèlement à l'autre rail, selon l'axe X. Dans des modes de réalisation préférés, l'ensemble électronique modulaire comporte deux rails et un raccord d'union pour assembler mécaniquement et électriquement lesdits deux rails.

Dans des exemples de réalisation, le raccord d'union est un raccord d'union droite. Un tel raccord d'union droite permet avantageusement d'assembler bout à bout deux rails, mécaniquement et électriquement. Par assembler bout à bout, on entend que les axes X de chaque rail sont confondus.

Dans des exemples de réalisation, le raccord d'union est un raccord d'union en forme de U. Un tel raccord d'union permet avantageusement d'assembler mécaniquement et électriquement deux rails accolés longitudinalement. Dans ces exemples de réalisation, les axes X des deux rails sont parallèles.

Dans des modes de réalisation préférés, l'ensemble électronique modulaire comporte deux rails et un module électronique bi-rail. Le module électronique bi-rail étant configuré pour, lorsque les deux rails sont accolés longitudinalement, être monté dans au moins un emplacement de chaque rail et à y être maintenu fixement de manière réversible dans une position opérante.

L'embase comporte, au niveau de chaque emplacement, une troisième cavité. Chaque module bi-rail présente les mêmes caractéristiques que le module à la différence près que le module bi-rail est dimensionné, pour se positionner dans deux emplacements de deux rails accolés longitudinalement, un emplacement par rail. Notamment, le module bi-rail comporte :
∘ un boîtier comportant un fond et un couvercle, le fond comportant un organe de retenue saillant vers l'extérieur dudit boîtier,
∘ une carte électronique logée dans le boîtier, comportant une broche de connexion formée d'une rangée de connecteurs males qui s'étendent hors du boîtier via une fenêtre traversante pratiquée dans le fond du boîtier,
∘ un organe de verrouillage comportant un levier monté libre en rotation par rapport au fond, ledit levier comportant, au niveau d'une partie proximale, deux crochets

Lorsqu'un module bi-rail est en position opérante dans un emplacement de chaque rail :
- le fond dudit module bi-rail est positionné en vis-à-vis des deux rails,
- l'organe de retenue du fond dudit module bi-rail est engagé dans la troisième cavité de l'embase d'un rail,
- chaque crochet du levier de l'organe de verrouillage du module bi-rail est engagé dans une deuxième cavité de l'embase de l'autre rail,
- la rangée de connecteurs males de la carte électronique du module bi-rail est en contact avec la rangée de connecteurs femelles d'un des deux rails.

La présente invention est également relative à un rail pour un ensemble électronique modulaire conforme à au moins l'un de ses modes de réalisation.

La présente invention est également relative à un module électronique pour un ensemble électronique modulaire conforme à au moins l'un de ses modes de réalisation.

### Brève description des figures

L'invention sera mieux comprise à la lecture de la description suivante, donnée à titre d'exemple nullement limitatif, et faite en se référant aux figures suivantes :
[Fig. 1] la figure 1 illustre un exemple d'un ensemble électronique modulaire illustrant différentes versions de modules électroniques ;
[Fig. 2] la figure 2 représente une vue en perspective d'un exemple de module électronique d'un ensemble électronique modulaire ;
[Fig. 3] la figure 3 représente une autre vue en perspective du module électronique de la figure 2 ;
[Fig. 4] la figure 4 représente une vue de dessous du module électronique de la figure 2 ;
[Fig. 5] la figure 5 représente une vue en perspective, par-dessus, d'un fond d'un boîtier du module électronique de la figure 2 ;
[Fig. 6] la figure 6 représente une vue en perspective, par-dessous, du fond du boîtier de la figure 5 ;
[Fig. 7] la figure 7 représente une vue en perspective, par-dessus, d'un couvercle d'un boîtier du module électronique de la figure 2 ;
[Fig. 8] la figure 8 représente une vue en perspective, par-dessous, du couvercle du boîtier de la figure 7 ;
[Fig. 9] la figure 9 représente une vue en perspective d'un autre exemple de couvercle d'un module ;
[Fig. 10] la figure 10 représente une vue en perspective d'un organe de verrouillage du module électronique de la figure 2 ;
[Fig. 11] la figure 11 représente une vue en perspective d'une carte électronique positionnée dans le boîtier du module de la figure 2 ;
[Fig. 12] la figure 12 représente une vue en perspective, par-dessus, d'un exemple d'une embase d'un rail d'un ensemble électronique modulaire ;
[Fig. 13] la figure 13 représente une vue en perspective, par-dessous, de l'embase du rail de la figure 11 ;
[Fig. 14] la figure 14 représente une vue en perspective d'un exemple d'un bus fond de panier d'un rail d'un ensemble électronique modulaire ;
[Fig. 15] la figure 15 représente un exemple de capuchon latéral destiné à être assemblé à une extrémité longitudinale d'un rail ;
[Fig. 16] la figure 16 représente une vue en coupe du module électronique de la figure 2, selon une coupe brisée à plans parallèles A-A représenté sur la figure 4. Dans ces figures, des références numériques identiques d'une figure à l'autre désignent des éléments identiques ou analogues. Par ailleurs, pour des raisons de clarté, les dessins ne sont pas à l'échelle, sauf mention contraire.

### Description des modes de réalisation

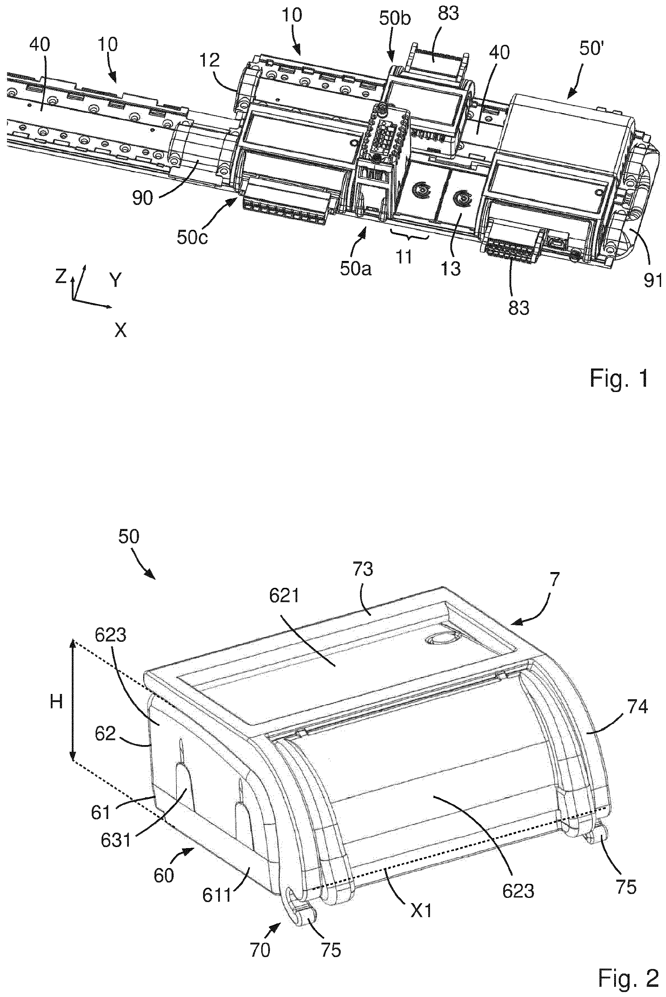

Un ensemble électronique modulaire 1 selon un exemple de réalisation, et illustré sur les figures 1 à 16, est un automate programmable. Dans la suite de la description, l'ensemble électronique modulaire 1 sera dénommé ensemble 1. L'ensemble 1 comporte au moins un rail 10 et au moins un module électronique 50. Chaque module électronique 50 est destiné à venir se fixer de manière réversible à un seul rail. Le module électronique 50 est un module mono-rail.

L'ensemble 1 peut comporter au moins un autre module électronique 50', dénommé module bi-rail. Chaque module bi-rail 50' est destiné à venir se fixer de manière réversible à deux rails accolés longitudinalement, comme il sera expliqué ultérieurement.

A titre illustratif, la figure 1 illustre un ensemble 1 avec trois rails 10, trois modules mono-rail 50a, 50b, 50c et un module bi-rail 50'.

Dans la suite de la description, on associera au rail 10, un repère XYZ, dans lequel :
- X désigne un axe longitudinal du rail, et correspond à une direction longitudinale du rail,
- Y désigne un axe perpendiculaire à X, et correspond à une direction transversale du rail,
- Z désigne un axe perpendiculaire à X et à Y.

Le rail 10 comporte une pluralité d'emplacements 11 destinés à recevoir des modules électroniques 50. Les emplacements 11 sont alignés les uns à côté des autres.

Dans l'exemple non limitatif de la figure 1, chaque rail 10 comporte neuf emplacements 11.

Le rail 10 comporte une embase 20 et une carte électronique dite bus fond de panier 40.

Le rail 10 sera décrit de manière plus détaillée ultérieurement.

Un module électronique, ou module mono-rail ou module 50, comporte un boîtier 60, destiné à venir se fixer de manière réversible à l'embase 20, une carte électronique 80 destinée à coopérer avec le bus fond de panier 40 et un organe de verrouillage 7.

Certains modules 50 présentent des dimensions adaptées en longueur pour s'insérer, à un jeu près, dans un seul emplacement 11 du rail 10. Ces modules sont dits modules simples. Un module simple est représenté sous la référence 50a sur la figure 1, à titre d'exemple.

Certains modules 50 présentent des dimensions, en longueur et en largeur, adaptées pour s'insérer, à un jeu près, dans plusieurs emplacements 11 adjacents du rail.

Un module 50 est monté sur le rail 10 jusqu'à une position dite opérante, dans laquelle ledit module 50 est en place dans le rail 10 et verrouillé, de manière réversible, dans son ou ses emplacements 11.

De préférence, certains modules 50 présentent des dimensions, en longueur et en largeur, pour s'insérer dans deux ou trois emplacements 11 adjacents du rail. Ces modules 50 sont dits modules doubles ou triples. Un module triple est représenté sous la référence 50c et un module double est représenté sous la référence 50b sur la figure 1, à titre d'exemple.

Les modules 50, qu'ils soient simple, double, triple..., peuvent présenter des hauteurs différentes, comme illustré sur la figure 1.

De préférence, les modules 50 présentent deux hauteurs standards. Les modules 50 sont dits module horizontal ou module vertical, selon leur hauteur. Un module vertical présente une hauteur au moins double du module horizontal.

Ainsi, dans l'exemple de la figure 1, sont illustrés un module horizontal triple 50c et un module vertical simple 50a.

Les modules 50 selon l'invention présentent des dimensions réduites par rapport au modules existants et présentent ainsi de nombreux avantages, notamment celui de pouvoir être utilisé dans des espaces restreints.

Dans un exemple non limitatif de réalisation, un module horizontal simple présente une dimension en longueur de 25,50 mm, en largeur de 53 mm et en hauteur de 25 mm. Un module horizontal double présente une même dimension en largeur et en hauteur que le module horizontal simple, mais présente une longueur de 51 mm. Un module horizontal triple présente une même dimension en largeur et en hauteur que le module horizontal simple, mais présente une longueur de 76,50 mm. Un module vertical simple présente une même dimension en longueur et en largeur que le module horizontal simple, mais présente une hauteur de 51,5 mm. Un module vertical double présente une même dimension en largeur et en hauteur que le module vertical simple, mais présente une longueur de 51 mm. Un module vertical triple présente une même dimension en largeur et en hauteur que le module vertical simple, mais présente une longueur de 76,5 mm.

### Module électronique - module mono-rail

Un exemple de module 50 est décrit sur les figures 2 à 11.

Comme décrit précédemment, un module 50 comporte un boîtier 60, une carte électronique 80 et un organe de verrouillage 7.

Le boîtier 60 définit un logement interne dimensionné pour recevoir la carte électronique 80.

Le boîtier 60 comporte préférentiellement deux parties, qui lorsqu'elles sont assemblées entre elles, délimite le logement interne dudit boîtier.

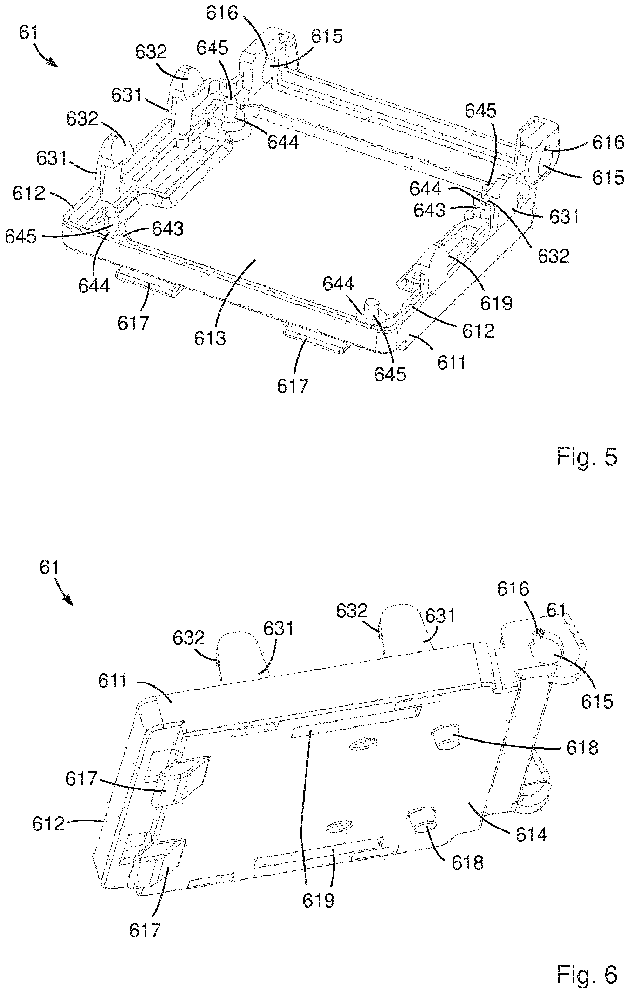

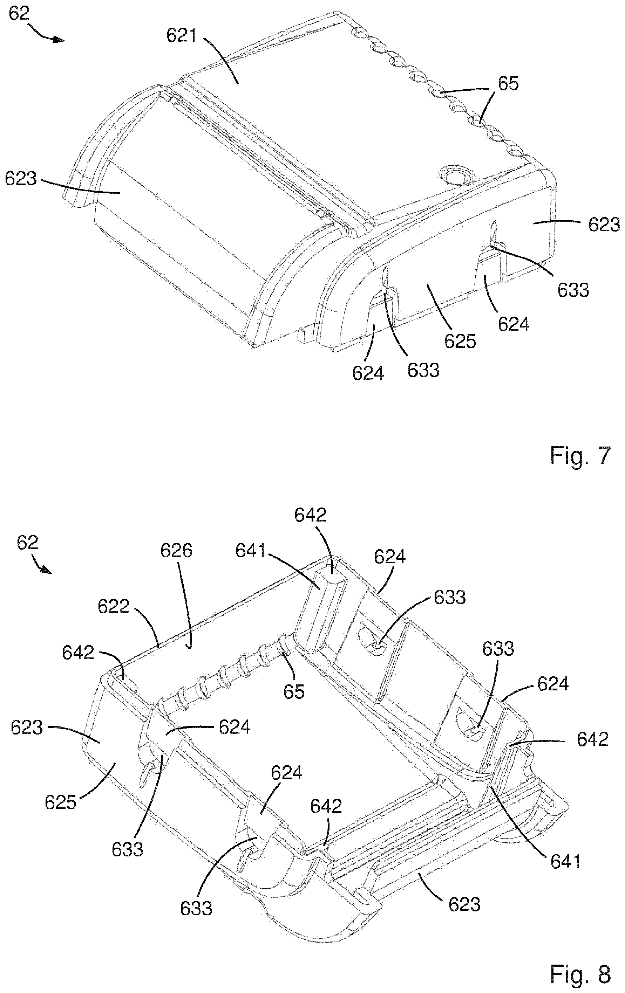

Une première partie du boîtier est dite fond 61 et est représentée sur les figures 5 et 6. Une deuxième partie du boîtier est dite couvercle 62 et est représentée sur la figure 7 à 9.

De préférence, le boîtier 60 présente, lorsque le fond 61 et le couvercle 62 sont assemblés, une forme générale sensiblement parallélépipédique.

Chaque boîtier 60 présente ainsi une longueur L, une largeur 1 et une hauteur H. Lorsqu'un module 50 est inséré dans un ou plusieurs emplacements 11 du rail 10, le boîtier 60 est positionné de sorte que sa longueur L s'étend selon l'axe X du rail, sa largeur l s'étend selon l'axe Y et sa hauteur H s'étend selon l'axe Z.

Lorsqu'un module 50 est inséré dans un ou plusieurs emplacements 11 du rail, le fond 61 du boîtier 60 est destiné à venir en vis-à-vis du rail 10.

Ainsi, le fond 61 du boîtier 60 d'un module 50 simple est dimensionné et configuré pour se conformer à la forme d'un emplacement 11 du rail. Par extension, le fond 61 du boîtier 60 d'un module 50 double, ou triple, est dimensionné et configuré pour se conformer à la forme de deux, ou trois, emplacements 11 adjacents du rail. Dans un exemple préféré de réalisation, non limitatif, le fond 61 comporte une paroi, dite paroi inférieure 611, comme illustré sur les figures 5 et 6. Le couvercle 62 comporte une paroi, dite paroi supérieure 621, et des parois latérales 623, ici au nombre de quatre, comme illustré sur les figures 6 à 8. La paroi supérieure 621 est destinée à venir en regard de la paroi inférieure 611 du fond 61 lorsque ledit fond et ledit couvercle sont assemblés. Les parois latérales 623 sont de préférence disposées au niveau d'un bord périphérique 622 de la paroi supérieure 621 et s'étendent sensiblement perpendiculairement à ladite paroi supérieure. Lesdites parois latérales 623 sont destinées à venir en regard d'un bord périphérique 612 de la paroi inférieure 611 du fond 61, lorsque le fond 61 et le couvercle 62 sont assemblés.

Rien n'empêche de réaliser un fond avec la paroi inférieure et les parois latérales et le couvercle avec la paroi supérieure.

Lorsqu'un module 50 est inséré dans un ou plusieurs emplacements 11 du rail 10, on nommera paroi latérale avant et paroi latérale arrière, les parois latérales 623 opposées et situées selon l'axe X du rail 10.

De préférence, le fond 61 et le couvercle 62 du boîtier 60 s'assemblent de manière réversible. Le boîtier 60 peut comprendre par exemple des moyens de clipsage pour maintenir en position le fond 61 et le couvercle 62 l'un par rapport à l'autre.

Tout autre moyen de fixation réversible approprié peut également être envisagé pour assembler le fond et le couvercle, sans se départir du cadre de l'invention. Dans un exemple préféré de réalisation, les moyens de clipsage comportent des premiers organes de clipsage disposés au niveau du fond 61, destinés à coopérer avec des deuxièmes organes de clipsage, complémentaires desdits premiers organes de clipsage, disposés au niveau du couvercle 62.

Dans une forme de réalisation, illustrés sur les figures 7 à 9, les deuxièmes organes de clipsage sont formés par au moins un orifice 633, traversant, ménagé dans au moins deux parois latérales 623, de préférence deux parois latérales opposées. Les premiers organes de clipsage du fond sont formés par au moins une patte flexible 631 qui s'étend depuis le bord périphérique 612 de la paroi inférieure 61 et qui comporte, à une extrémité libre, un ergot 632, comme illustré sur les figures 5 et 6. Chaque patte flexible 631 est agencée de manière à se déformer puis à venir loger l'ergot 632 associé dans un orifice 633 traversant, lorsque le couvercle 62 s'assemble au fond 61.

Dans l'exemple non limitatif des figures 5 et 8, les moyens de clipsage sont formés par deux orifices 633 traversants ménagés dans deux parois latérales 623 opposées du couvercle 62 et quatre pattes flexibles 631 avec ergot 632 au niveau de la paroi inférieure 611.

La déformation des pattes flexibles 631 pour le clipsage et le déclipsage du fond 61 et du couvercle 62 se réalise vers l'extérieur du boîtier 60.

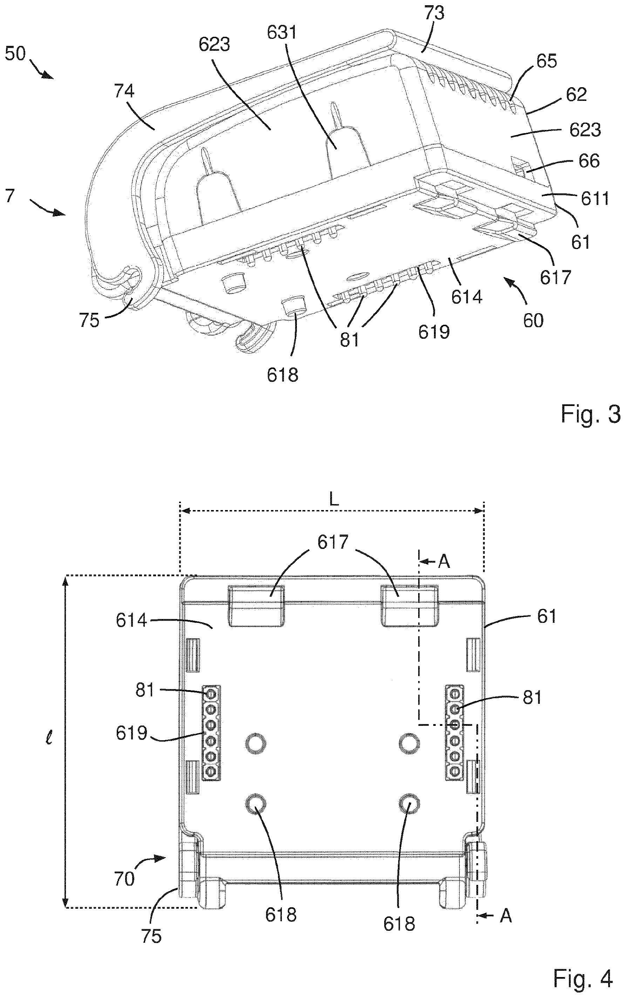

Les parois latérales 623 recevant les deuxièmes organes de clipsage comportent au moins un renfoncement 624, s'étendant depuis une face externe 625, et dimensionné pour recevoir une patte flexible 631 des premiers organes de clipsage, de sorte que, lorsque le fond 61 et le couvercle 62 sont assemblés, chaque patte flexible 631 est affleurante avec une face externe 625 de la paroi latérale 623 associée, comme illustré sur les figures 2 et 3.

Par face externe d'une paroi latérale ou de la paroi supérieure ou de la paroi inférieure, et par extension du couvercle et du fond, on entend la face opposée à une face interne qui est disposée du côté du logement interne du boîtier.

Ainsi, la face externe du fond correspond à la face externe de la paroi inférieure et la face interne du fond correspond à la face interne de la paroi inférieure. La face externe du couvercle correspond à l'ensemble des faces externes des paroi latérales et de la paroi supérieure. La face interne du couvercle correspond à l'ensemble des faces internes des paroi latérales et de la paroi supérieure.

Dans un mode de réalisation, le boîtier 60 comporte des éléments de maintien en position de la carte électronique 80 dans ledit boîtier.

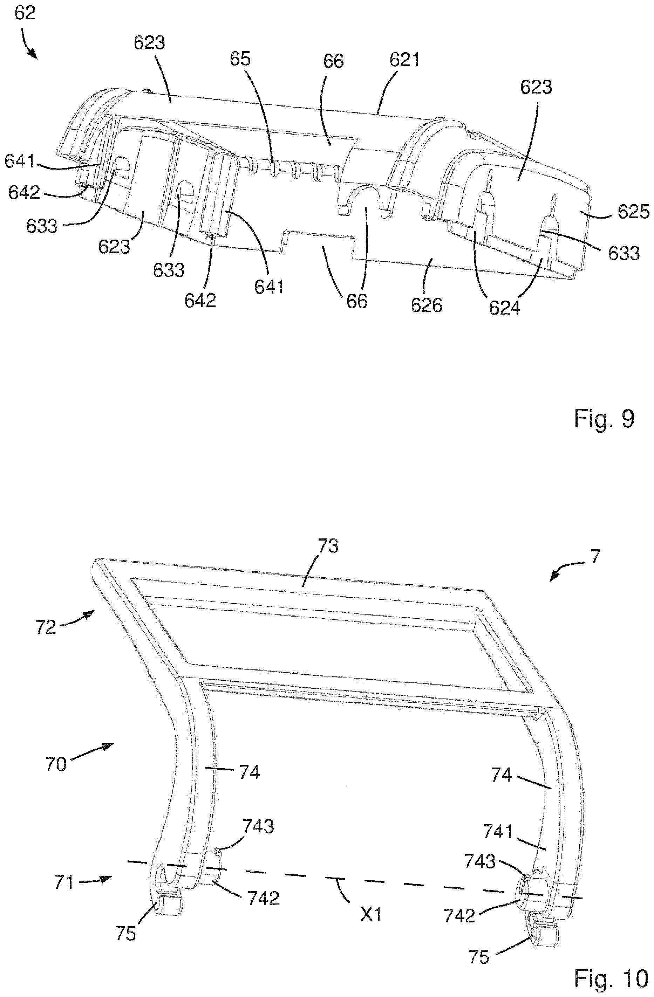

Dans un exemple de réalisation des éléments de maintien en position, illustré sur les figures 8 et 9, le couvercle 62 peut comporter, au niveau d'une face interne 626, des nervures formant des épaulements 641. Chacun de ses épaulements 641 présente une surface d'appui 642. Les surfaces d'appui 642 des épaulements 641 du couvercle 62 sont contenues dans un même plan, dit premier plan. Le fond 61 peut comporter, comme illustré sur la figure 5, des pions, s'étendant par exemple depuis une face interne 613 de la paroi inférieure 611, et formant des épaulements 643. Chacun de ses épaulements 643 présente une surface d'appui 644. Les surfaces d'appui 644 des épaulements 643 du fond 61 sont contenues dans un même plan, dit second plan. Dans l'exemple illustré sur la figure 5, le fond 61 comporte quatre surfaces d'appui 644.

Les surfaces d'appui 642 des épaulements 641 du couvercle 62 sont de préférence situées chacune à proximité d'une surface d'appui 644 d'un épaulement 643 du fond 61. Ainsi, lorsque le fond 61 et le couvercle 62 du boîtier 60 sont assemblés, le premier plan et le deuxième plan sont sensiblement parallèles, séparés d'une distance, dite écart d'appui. Cet écart d'appui correspond avantageusement sensiblement à une épaisseur de la carte électronique 80, voire peut lui être légèrement inférieur. Ainsi, simplement en logeant la carte électronique 80 entre le fond 61 et le couvercle 62 du boîtier 60, et en refermant le couvercle 62 et le fond 61 l'un sur l'autre, la carte électronique 80 est prise en étau entre les surfaces d'appui 642 des épaulements 641 dudit couvercle et les surfaces d'appuis 644 des épaulements 643 dudit fond.

Dans un autre exemple de réalisation des éléments de maintien en position, en complément ou non du précédent exemple de réalisation, pour garantir le positionnement de la carte électronique 80 dans le boîtier 60 avant de le refermer, les épaulements 643 du fond 61 sont pourvus chacun d'un picot 645 s'étendant depuis la surface d'appui 644 dudit épaulement, comme illustré sur la figure 5. Chaque picot 645 est configuré pour être inséré dans des orifices traversants 84 ménagés dans l'épaisseur de la carte électronique 80. De préférence, un picot 645 présente une dimension, en hauteur, sensiblement équivalente, ou au plus égale, à l'épaisseur de la carte électronique 80.

Le module 50 comporte en outre un organe de verrouillage 7 destiné à maintenir en position opérante le module 50 sur le rail 10, lorsque ledit module est installé sur le rail 10.

De préférence, comme illustré sur les figures 2, 3, l'organe de verrouillage comporte un levier 70, monté libre en rotation par rapport au fond 61.

Ce levier 70 comporte une partie proximale 71 destinée à être reliée au fond 61 et une partie distale 72 définissant une partie de préhension pour un utilisateur du module 50.

Dans une forme préférée de réalisation, illustrée figure 10, le levier 71 est formé par deux bras 74 reliés entre eux par une branche transversale 73, par exemple au niveau de la partie distale 72.

Les deux bras 74 comportent chacun, au niveau d'une face intérieure 741, tournée vers le fond 61, un pion de montage 742 qui est destiné à être inséré dans un orifice 615 du fond 61.

Les pions de montage 742 sont de préférence disposés au niveau de la partie proximale 71 du levier 70.

Les pions de montage 742, de préférence de forme cylindrique, forment des pivots autorisant le pivotement du levier 70 autour d'un axe de rotation X1 transversal audit levier passant par ces pions de montage.

De préférence, les pions de montage 742 sont disposés au niveau d'un côté de la paroi inférieure 611.

Lorsqu'un module 50 est inséré dans un ou plusieurs emplacements 11 du rail, le boîtier 60 est positionné de sorte que l'axe X1 est parallèle à l'axe X du rail.

Le levier 70 comporte, au niveau de la partie proximale 71, deux crochets 75, un crochet par bras. Chaque crochet 75 est destiné à coopérer avec un élément spécifique du rail, comme il sera expliqué en détail ultérieurement.

Le levier 70 est mobile autour de son axe de rotation entre une position verrouillée, dans laquelle chaque crochet 75 coopère avec ledit élément spécifique du rail, et une position déverrouillée, dans laquelle chaque crochet 75 ne coopère pas avec ledit élément spécifique.

De préférence, pour faciliter le montage et le démontage du module 50, le levier 70 est amovible.

Dans un exemple de réalisation, les pions de montage 742 comportent chacun une excroissance radiale 743 destinée à coopérer avec une empreinte 616 complémentaire au niveau de l'orifice 615 associé du fond.

Le positionnement de l'excroissance radiale 743 sur les pions de montage 742 et celui de l'empreinte 616 complémentaire des orifices 615 associés du fond ont été définis et agencés de telle sorte que le levier 70 ne peut être monté sur le fond 61 qu'en l'absence du couvercle 62.

Une fois le couvercle 62 associé au fond, si le levier 70 n'a pas été relié au fond 61, il n'est plus possible de le faire. Si le levier 70 a été relié au fond 61, il n'est plus possible de retirer le levier, sauf à enlever en premier lieu le couvercle 62.

De préférence, la paroi inférieure 611 du fond 61 et au moins une paroi latérale 623 du couvercle 62 peuvent comporter un décrochement dimensionné pour recevoir les deux bras 74 du levier 70, de sorte que, lorsque le fond 61 et le couvercle 62 sont assemblés, les deux bras 74 sont affleurants avec la face externe du couvercle 62.

Dans un mode de réalisation, comme illustré sur les figures 3,6, 11, le fond 61 du boîtier 60 comporte au moins un organe de retenue 617 saillant vers l'extérieur du boîtier 60. Ledit au moins un organe de retenue 617 est saillant depuis la face externe 614 de la paroi inférieure 611 du fond 61. Ledit au moins un organe de retenue 617 est destiné à coopérer avec un élément spécifique du rail, comme il sera expliqué ultérieurement.

L'au moins un organe de retenue 617 participe avantageusement, avec le levier 70, au maintien fixe du module 50 dans le rail 10.

Dans l'exemple du module simple, le boîtier 60 ne comporte qu'un organe de retenue 617.

Dans l'exemple du module double, le boîtier 60 comporte deux organes de retenue. Dans l'exemple du module triple, le boîtier 60 peut comporter deux ou trois organes de retenue 617.

Dans un mode de réalisation, illustré figures 3 et 6, le fond 61 du boîtier 60 comporte un plot d'orientation 618.

Le plot d'orientation 618 est saillant vers l'extérieur du boîtier 60, depuis la face externe 614 de la paroi inférieure 611 du fond 61.

Ledit plot d'orientation est destiné à coopérer avec un élément spécifique du rail, comme il sera expliqué ultérieurement.

Le plot d'orientation 618 permet avantageusement d'empêcher le positionnement du boîtier 60 sur le rail 10, lorsque ledit boîtier n'est pas positionné sur le rail 10 dans le bon sens. En d'autres sens, le plot d'orientation 618 du module fait office de détrompeur.

De préférence, le boîtier 60 et l'organe de verrouillage sont réalisés dans une matière rigide, par exemple en Polycarbonate/Acrylonitrile Butadiène Styrène (acronyme : PC/ABS).

De préférence, le boîtier 60 et l'organe de verrouillage sont réalisés par moulage par injection.

Comme décrit précédemment, le module 50 comporte une carte électronique 80.

Ladite carte électronique est préférentiellement une carte de circuit imprimé ou PCB (de l'anglais « Printed Circuit Board ») qui comporte un support 85 en forme de plaque permettant de maintenir et de relier électriquement entre eux une pluralité de composants électroniques.

Préférentiellement, une carte électronique est réalisée pour conférer au module la contenant, une ou plusieurs fonctionnalités distinctes, telle que par exemple le contrôle de sorties digitales, le contrôle des motorisations, l'analyse des entrées analogiques, la communication cellulaire.

La carte électronique 80 d'un module 50 est destinée à s'interfacer avec le bus fond de panier 40 du rail 10, comme illustré sur les figures 4 et 5.

La carte électronique 80 du boîtier 50 comporte préférentiellement au moins une broche de connexion formée d'une rangée de connecteurs males 81, alignés, et destinés à coopérer avec une rangée de connecteurs femelles 42 du bus fond de panier 40 du rail 10. De manière plus préférentielle, la carte électronique 80 du module 50 comporte deux broches de connexion.

De préférence, la au moins une broche de connexion s'étend depuis une face 82 de ladite carte électronique en vis-à-vis avec le fond 61 lorsque la carte électronique est en position dans le boîtier 60.

Dans l'exemple non limitatif des figures 3 et 4, la carte électronique 80 comporte deux broches de connexion, chaque broche de connexion comportant une rangée de six connecteurs males 81.

Dans un exemple de réalisation, les connecteurs males 81 sont des plots à ressorts. Pour permettre le passage des connecteurs males 81 hors du boîtier 60, le fond 61 comporte au moins une fenêtre traversante 619, en vis-à-vis de la au moins une broche de connexion, lorsque la carte électronique 80 est en position dans le boîtier 60.

De préférence, le fond 61 du boîtier 60 comporte deux fenêtres traversantes 619, comme illustré sur les figures 3 à 5.

Dans un mode de réalisation, comme illustré sur les figures 3, 5, 7, le boîtier 60 comporte des trous d'aération 65. Lesdits trous d'aération permettent avantageusement de faire passer les flux d'air pour le refroidissement des composants électroniques de la carte électronique 80 du module 50.

De préférence, les trous d'aération 65 sont pratiqués dans le couvercle 62, au niveau d'au moins une des parois latérales 623 et/ou de la paroi supérieure 621.

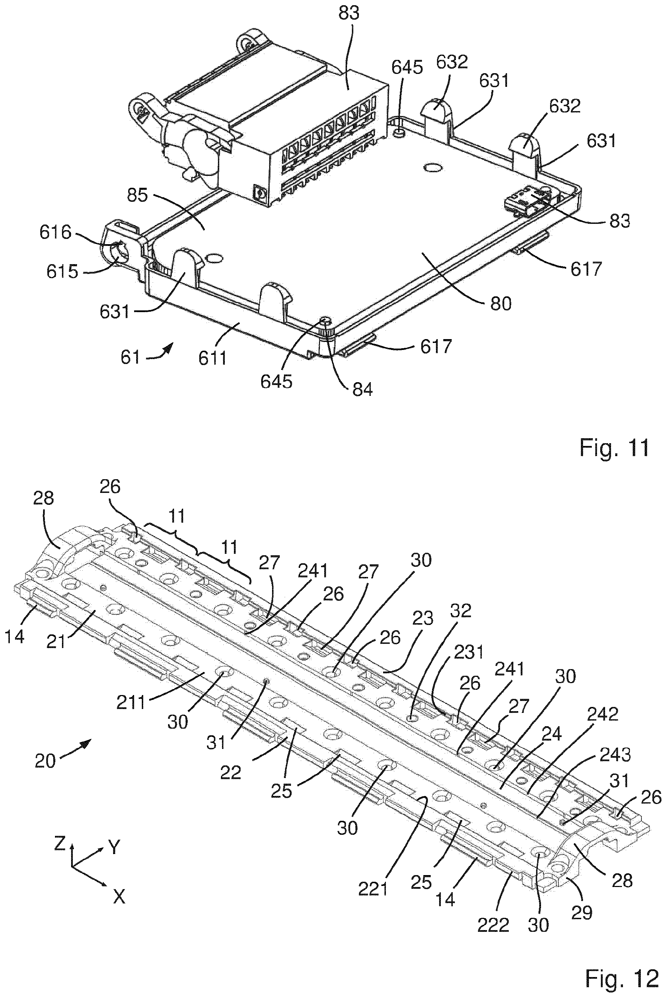

Dans un mode de réalisation, comme illustré sur la figure 11, la carte électronique 80 du module 50 peut comporter au moins un connecteur, dit connecteur secondaire 83, destiné à interagir avec au moins un connecteur de type soit informatique soit industriel, tel que par exemple un connecteur micro USB type A/B.

Pour permettre le passage d'au moins un connecteur secondaire 83 hors du boîtier 60, ledit boîtier peut comporter, comme illustré sur la figure 9, une ouverture traversante 66 pratiquée dans le couvercle 62, au niveau d'au moins une des parois latérales 623 et/ou de la paroi supérieure 621, en vis-à-vis du connecteur secondaire 83 lorsque la carte électronique 80 est en position dans le boîtier 60. Dans un exemple préféré de réalisation, pour un module 50 horizontal, le boîtier 60 comporte une ouverture traversante 66 au niveau de la paroi latérale avant du couvercle 62 pour le passage d'un connecteur secondaire de type industriel et comporte une ouverture traversante 66 au niveau de la paroi latérale arrière du couvercle 62 pour le passage d'un connecteur secondaire de type informatique. Pour un module 50 vertical, le boîtier 60 comporte une ouverture traversante 66 au niveau de la paroi latérale avant du couvercle 62 pour le passage d'un connecteur secondaire de type informatique et comporte une ouverture traversante 66 au niveau de la paroi supérieure 621 du couvercle 62 pour le passage d'un connecteur secondaire de type industriel.

Dans l'exemple illustré sur la figure 1, non limitatif, pour le module 50c, le boîtier comporte une ouverture traversante au niveau d'une des parois latérales du couvercle pour le passage d'un connecteur secondaire 83 de type industriel. Le boîtier du module 50a comporte une ouverture traversante au niveau de la paroi supérieure du couvercle pour le passage d'un connecteur secondaire 83 de type industriel.

Dans un mode de réalisation, le boîtier 60 peut comporter une portion sécable (non représentée). Ladite portion sécable peut consister en une réduction locale de l'épaisseur du couvercle 62. L'application d'une force, par exemple une pression exercée par un doigt, sur cette portion sécable provoque sa casse et crée une ouverture pour le passage d'un connecteur, par exemple un connecteur d'antenne.

### Rail

Le rail 10 comporte une embase 20 et un bus fond de panier 40.

L'embase 20 est destinée à recevoir d'une part le bus fond de panier 40 et d'autre part des modules 50.

Le bus fond de panier 40 est destiné à établir la liaison entre les différents modules 50 installée sur le rail 10.

Le bus fond de panier 40 peut être amovible de l'embase 20.

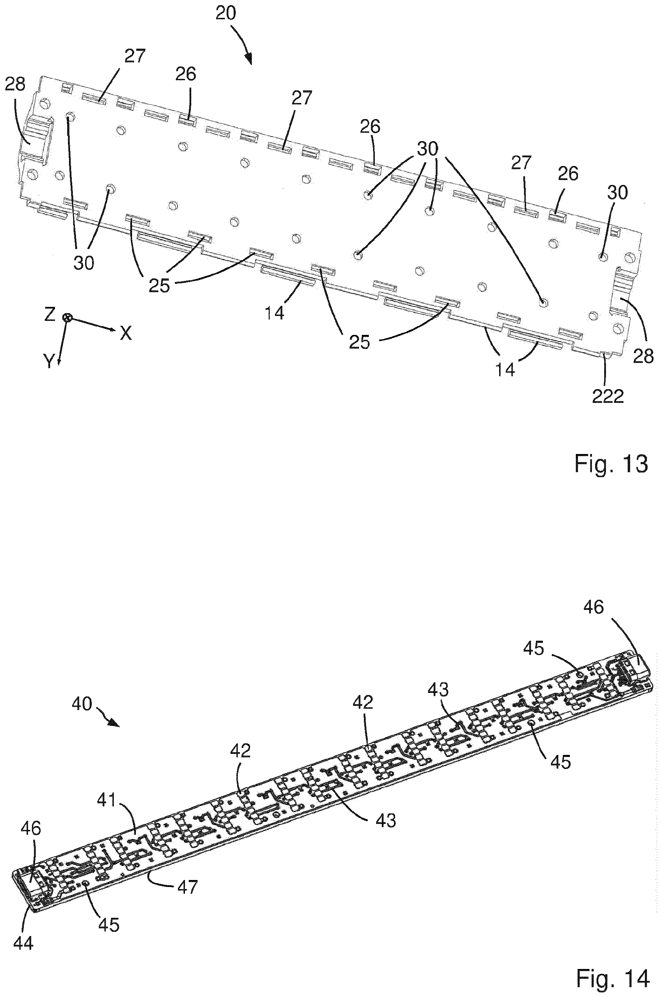

Le bus fond de panier 40 se présente, comme illustré figure 14, sous la forme d'un support en forme de plaque. Le bus fond de panier 40 présente une forme allongée selon l'axe X.

Le bus fond de panier 40 comporte sur une face, dite face supérieure 41, une pluralité de rangées de connecteurs femelles 42 et un ensemble de pistes conductrices 43 reliant entre eux notamment les différents connecteurs femelles 42. Chaque rangée de connecteurs femelles 42 est destinée à coopérer à une rangée de connecteurs males 81 d'une carte électronique 80 d'un module 50.

Les rangées de connecteurs femelles 42 sont disposées sur le bus fond de panier 40 de telle sorte que, lorsque le bus fond de panier 40 est en place dans l'embase 20, chaque emplacement 11 du rail 10 comporte une ou deux rangées de connecteurs femelles 42.

Dans un exemple de réalisation, les connecteurs femelles 42 se présentent sous la forme d'un plot de cuivre nu.

De préférence, le bus fond de panier 40 comporte, au niveau d'extrémités longitudinales 44, un connecteur, dit d'extrémité 46, destiné à coopérer, de manière indirecte, à un autre connecteur d'extrémité 46 d'un autre rail.

L'embase 20, comme illustrée sur les figures 12 et 13, présente une forme allongée selon l'axe X.

De préférence, l'embase 20 est symétrique par rapport à un plan latéral médian YZ du rail.

De préférence, l'embase 20 est réalisée dans une matière rigide, par exemple en Polycarbonate/Acrylonitrile Butadiène Styrène (acronyme : PC/ABS).

De préférence, l'embase 20 est réalisée par moulage par injection.

Dans une version de réalisation préférée, l'embase 20 présente, en section transversale, dans un plan YZ, une forme sensiblement en U.

L'embase 20 comporte une âme longitudinale, dite âme 21, et deux ailes longitudinales, dites première aile 22 et seconde aile 23. Les deux ailes 22, 23 sont disposées de part et d'autre de l'âme 21.

De manière préférentielle, chacune des deux ailes 22, 23 s'étend sensiblement verticalement depuis une face, dite face supérieure 211, de l'âme 21.

Chacune des deux ailes 21, 22 présente une face longitudinale interne, du côté de l'âme, formant un rebord longitudinal, dit premier rebord 221, 222.

Les premiers rebords 221, 222 contribuent avantageusement au guidage et au maintien des modules 50 dans l'embase 20.

L'embase 20 comporte une rainure longitudinale 24. Cette rainure longitudinale 24 est pratiquée dans l'âme 21.

De préférence, la rainure longitudinale 24 est symétrique par rapport au plan longitudinal médian XY du rail 10.

La rainure longitudinale 24 forme avantageusement une glissière de réception du bus fond de panier 40. Ainsi, le bus fond de panier 40 s'insère dans la rainure longitudinale 24 par coulissement depuis une extrémité longitudinale 29 de l'embase 20.

De préférence, la rainure longitudinale 24 s'étend sur toute la longueur de l'embase 20. Ainsi, le bus fond de panier 40 s'insère dans la rainure longitudinale 24 de l'embase 20 par coulissement indifféremment depuis l'une des deux extrémités longitudinales 29 de l'embase 20.

Ladite rainure longitudinale présente une épaisseur sensiblement égale à l'épaisseur du bus de fond de panier 40, c'est-à-dire à l'épaisseur du support en forme de plaque, de sorte que, lorsque le bus fond de panier 40 est en position dans la rainure longitudinale 24 de l'embase 20, la face supérieure 41 du bus fond de panier 40 est affleurante avec la face supérieure 211 de l'âme 21.

La face supérieure 41 du bus fond de panier 40 et la face supérieure 211 de l'âme 21 forme ainsi avantageusement un plan de réception des modules 50. Ladite rainure longitudinale présente une largeur, selon l'axe Y, sensiblement égale à la largeur du bus fond de panier 40, à un jeu près, de sorte à permettre l'insertion du bus fond de panier 40 dans la rainure longitudinale 24 sans forcer.

Dans une forme de réalisation, la rainure longitudinale 24 peut comporter des protubérances 241 qui s'étendent depuis des bords longitudinaux 242 de ladite rainure longitudinale, dimensionnées pour rattraper le jeu dans ladite rainure longitudinale, centrer et maintenir le bus fond de panier 40 dans la rainure longitudinale sans forcer pour le mettre en position. De préférence, lesdites protubérances 241 sont disposées à intervalles réguliers au niveau de chaque bord longitudinal 242, selon une disposition symétrique par rapport au plan longitudinal médian XY.

L'embase 20 comporte une pluralité de premières cavités 25. Chaque première cavité 25 est configurée pour recevoir un organe de retenue 617 d'un module 50.

De préférence, les premières cavités 25 sont disposées sensiblement au niveau de l'intersection entre l'âme 21 et le premier rebord 221 de la première aile 22.

Les premières cavités 25 sont préférentiellement réparties sur la longueur de l'embase 20 et disposées à intervalles réguliers.

Les premières cavités 25 sont disposées de telle sorte que chaque emplacement 11 du rail 10 comporte une première cavité 25. De préférence, chaque première cavité 25 est centrée dans l'emplacement 11.

Chaque première cavité 25 est préférentiellement dimensionnée pour ne recevoir qu'un seul organe de retenue 617 d'un module 50.

Dans une forme de réalisation, chaque première cavité 25 est biseautée au niveau de l'âme 21 pour accompagner et faciliter l'insertion d'organe de retenue 617 du module 50.

Dans une forme de réalisation, les premières cavités 25 sont préférentiellement traversantes, comme illustré sur les figures 12, 13.

L'embase 20 comporte une pluralité de deuxièmes cavités 26. Chaque deuxième cavité 26 est configurée pour recevoir au moins un crochet 75 du levier 70 de l'organe de verrouillage d'un module 50.

De préférence, les deuxièmes cavités 26 sont disposées sensiblement au niveau de l'intersection entre l'âme 21 et le premier rebord 231 de la deuxième aile 23. Les deuxièmes cavités 26 sont préférentiellement réparties sur la longueur de l'embase 20 et disposées à intervalles réguliers.

Chaque deuxième cavité 26 est dimensionnée pour recevoir deux crochets 75 de deux leviers 70 de deux modules 50 accolés.

Les deuxièmes cavités 26 sont disposées à cheval sur deux emplacements 11 attenants, de telle sorte que chaque emplacement 11 de rail 10 comporte une partie d'une deuxième cavité 26. En d'autres termes, les deuxièmes cavités 26 sont disposées en quinconce, par rapport aux premières cavités 25.

Dans une forme de réalisation, chaque deuxième cavité 26 est biseautée au niveau de l'âme 21 pour accompagner et faciliter l'insertion du au moins un crochet 75 du levier 70 de l'organe de verrouillage.

Dans une forme de réalisation, les deuxièmes cavités 26 sont préférentiellement traversantes, comme illustré sur les figures 12, 13.

Dans un mode de réalisation, l'embase 20 comporte une pluralité de trous de fixation 30 pour permettre avantageusement le passage d'éléments de fixation, tel que par exemple des vis, destinés à maintenir le rail 10 à un support, de manière sécurisée.

De préférence, les trous de fixations 30 sont pratiqués au niveau de l'âme 21.

Dans l'exemple préféré de la figure 12, mais nullement limitatif, les trous de fixation 30 sont disposés de part et d'autre de la rainure longitudinale 24, à intervalles réguliers le long de ladite rainure longitudinale. Lesdits trous de fixation 30 sont préférentiellement agencés selon une disposition symétrique par rapport au plan longitudinal médian XY du rail.

Dans un mode de réalisation, l'embase 20 comporte, dans la rainure longitudinale 24, une cannelure longitudinale 243. De préférence, la cannelure longitudinale 243 est réalisée sur toute la longueur de la rainure longitudinale 24 de l'embase 20. Cette cannelure longitudinale 243 est une cannelure dite de réservation pour avantageusement recevoir, si nécessaire, des composants électroniques qui s'étendraient depuis une face inférieure 47, face opposée à la face supérieure 41, du bus fond de panier 40.

Dans un mode de réalisation, l'embase 20 comporte, dans la rainure longitudinale 24, au moins un élément de détrompage 31, de préférence une pluralité d'éléments de détrompage. Le au moins un élément de détrompage 31 a avantageusement pour rôle de s'assurer que le bus fond de panier 40 est inséré et positionné dans l'embase 20 dans le bon sens.

Par exemple, le au moins un élément de détrompage 31 se présente sous la forme d'un pion de positionnement.

Chaque élément de détrompage est saillant depuis un fond de la rainure longitudinale 24. Chaque élément de détrompage 31 est destiné à coopérer avec un orifice 45 complémentaire pratiqué dans tout ou partie de l'épaisseur du bus fond de panier 40, lorsque le bus fond de panier 11 est dans la bonne position dans la rainure longitudinale 24 de l'embase 20.

Lorsqu'il y a plusieurs éléments de détrompage 31, ceux-ci sont disposés de manière non symétrique par rapport au plan longitudinal médian XY du rail.

Le au moins un élément de détrompage 31 peut également jouer le rôle de centrage et de maintien du bus fond de panier 40 dans la rainure longitudinale 24, en complément ou non des protubérances 241 de la rainure longitudinale 24.

Dans l'exemple de la figure 12, quatre éléments de détrompage 31 sont représentés.

Dans un mode de réalisation, pour empêcher le retrait du bus fond de panier 40 de la rainure longitudinale 24 de l'embase selon l'axe Z du rail, ladite embase comporte, à ses extrémités longitudinales 29, un renflement 28, traversant selon l'axe X, dimensionné, à un jeu près, pour permettre le passage du bus fond de panier 40 et ses connecteurs d'extrémités 46. Lorsque le bus fond de panier 40 est en position dans la rainure longitudinale 24 de l'embase 20, chaque renflement 28 recouvre un connecteur d'extrémité 46 du bus fond de panier 40. Les renflements 28 permettent également avantageusement de protéger lesdits connecteurs d'extrémités 46.

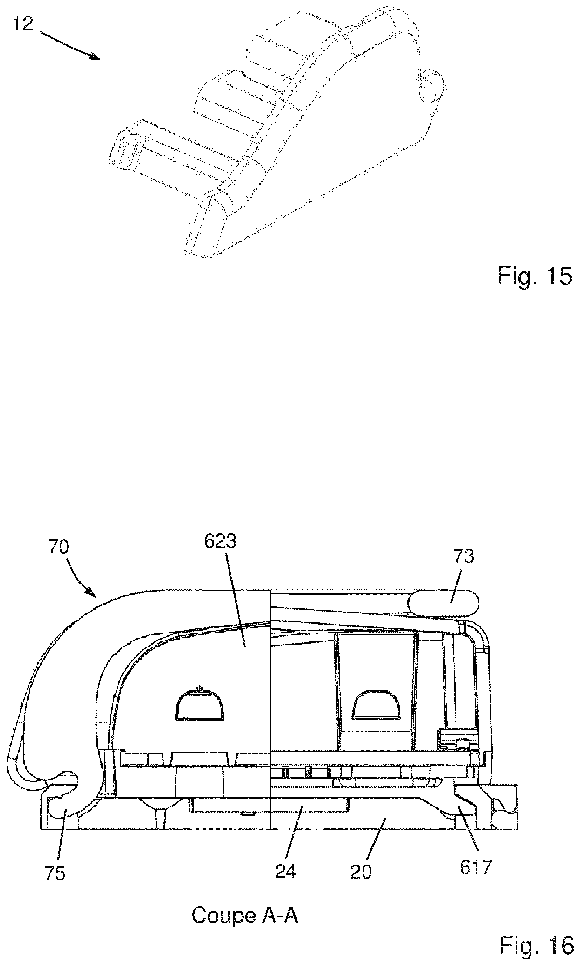

Dans un mode de réalisation, pour protéger un connecteur d'extrémité 46 du bus fond de panier 40 d'éventuelles agressions mécaniques extérieures, lorsque ledit connecteur d'extrémité n'est pas utilisé, le rail 10 comporte un capuchon latéral 12, comme illustré sur les figures 1 et 15, destiné à coopérer avec un renflement 28 de l'embase 20. Ledit capuchon latéral est préférentiellement apte à être emboité dans le renflement 28, par clipsage.

Dans un mode de réalisation, le rail 10 comporte des éléments de clipsage 14, de préférence au niveau d'une face longitudinale externe 222 de la première aile 22 de l'embase 20.

La face longitudinale externe 22 de la première aile 22 de l'embase 20 est la face opposée à la face longitudinale interne de la première aile de l'embase, celle formant le premier rebord 221.

Lesdits éléments de clipsage du rail 10 sont configurés et positionnés pour coopérer avec les éléments de clipsage d'un autre rail 10 similaire.

Lorsque les éléments de clipsage 14 de chaque rail 10 coopèrent, les deux rails 10 sont accolés longitudinalement, au niveau des premières ailes 22 de l'embase 20 de chacun. Les deux rails 10 sont parallèles entre eux selon l'axe X.

De tels éléments de clipsage 14, lorsqu'ils coopèrent, permettent un maintien en position d'un rail 10 par rapport à l'autre.

Dans un mode de réalisation, comme illustré sur la figure 1, l'ensemble 1 peut comporter un autre module électronique, dénommé module bi-rail 50'. Le module bi-rail 50' présente les mêmes caractéristiques que le module 50 présenté ci-avant à la différence près que le module bi-rail 50' est dimensionné, en largeur, pour se positionner dans deux emplacements 11 de deux rails 10 accolés longitudinalement, un emplacement par rail.

Ainsi, le fond d'un tel module bi-rail 50' est dimensionné et configuré pour se conformer à la forme des emplacements 11 des deux rails, et comporte notamment un décrochement 51' pour permettre de chevaucher les deux premières ailes 22 accolés des embases 20 de chaque rail 10.

Notamment, parmi les caractéristiques communes non exhaustives, le module bi-rail 50' comporte un boîtier comportant un fond et un couvercle, le fond comportant un organe de retenue saillant vers l'extérieur dudit boîtier. Le module bi-rail 50' comporte une carte électronique logée dans le boîtier, comportant une broche de connexion formée d'une rangée de connecteurs males qui s'étendent hors du boîtier via une fenêtre traversante pratiquée dans le fond du boîtier. Le module bi-rail 50' comporte un organe de verrouillage 7 comportant un levier monté libre en rotation par rapport au fond, ledit levier comportant, au niveau d'une partie proximale, deux crochets.

Le module bi-rail 50' se décline également en module bi-rail simple, double ou triple, comme pour le module 50.

Le module bi-rail 50' se décline également en module bi-rail horizontal ou vertical, comme pour le module 50.

Dans l'exemple de la figure 1, est ainsi représenté un module bi-rail 50' vertical simple.

Tout comme les modules 50, les modules bi-rail 50' présentent des dimensions réduites par rapport au modules existants et présentent l'avantage, notamment, de pouvoir être utilisé dans des espaces restreints.

Dans un mode de réalisation, illustré sur les figures 12, 13, l'embase 20 comporte une pluralité de troisièmes cavités 27. Chaque troisième cavité 27 est configurée pour recevoir un organe de retenue (non représenté sur les figures) d'un module bi-rail 50'.

De préférence, les troisièmes cavités 27 sont disposées sensiblement au niveau de l'intersection entre l'âme 21 et le premier rebord 231 de la deuxième aile 23.

Ces troisièmes cavités 27 ne sont utilisées que dans une configuration où deux rails 10 sont accolés longitudinalement et qu'un module bi-rail 50' est disposé sur lesdits deux rails. Dans cette configuration, un module bi-rail 50' est maintenu aux deux rails 10, via d'une part, les troisièmes cavités 27 d'un rail 10, et d'autre part, les deuxièmes cavités 26 de l'autre rail 10.

Les troisièmes cavités 27 sont préférentiellement réparties sur la longueur de l'embase 20 et disposées à intervalles réguliers.

Les troisièmes cavités 27 sont disposées à intervalles réguliers, entre deux deuxièmes cavités 26 consécutives.

Les troisièmes cavités 27 sont disposées de telle sorte que chaque emplacement 11 du rail 10 comporte une troisième cavité 27. De préférence, les troisièmes cavités 27 sont agencées, par rapport au plan longitudinal médian XY du rail, de manière symétrique aux premières cavités 25.

Chaque troisième cavité 27 est préférentiellement dimensionnée pour ne recevoir qu'un seul organe de retenue d'un module bi-rail 50'.

Dans une forme de réalisation, chaque troisième cavité 27 est biseautée au niveau de l'âme 21 pour faciliter l'insertion dudit organe de retenue.

Dans une forme de réalisation, les troisièmes cavités 27 sont préférentiellement traversantes, comme illustré sur les figures 12 et 13.

Lorsqu'un module bi-rail est en position opérante dans un emplacement de chaque rail :
- le fond dudit module bi-rail est positionné en vis-à-vis des deux rails,
- l'organe de retenue du fond dudit module bi-rail est engagé dans la troisième cavité de l'embase d'un rail,
- chaque crochet du levier de l'organe de verrouillage du module bi-rail est engagé dans une deuxième cavité de l'embase de l'autre rail,
- la rangée de connecteurs males de la carte électronique du module bi-rail est en contact avec la rangée de connecteurs femelles d'un des deux rails.

Dans un mode de réalisation, pour protéger le bus fond de panier 40 dans un rail 10, lorsqu'un emplacement 11 n'est pas utilisé par un module 50, le rail 10 comporte un capot de protection 13, comme illustré sur la figure 1. Le capot de protection 13 est dimensionné pour recouvrir l'âme 21 de l'embase 20 et le fond de panier 40, au niveau d'un emplacement 11 non utilisé.

Dans un exemple de réalisation, le capot de protection 13 est destiné à s'insérer dans la première cavité 25 et les deuxièmes cavités 26 dudit emplacement.

Dans un autre exemple de réalisation, lorsque l'embase 20 comporte des troisièmes cavités 27, le capot de protection 13 est destiné à s'insérer dans la première cavité 25 et la troisième cavité 27 dudit emplacement.

Dans un mode de réalisation, l'embase 20, préférentiellement l'âme 21, comporte, au niveau de chaque emplacement 11 du rail 10, un trou de réception 32 d'un plot d'orientation 618 d'un module 50.

L'embase 20 présentant une symétrie selon le plan longitudinal médian XY du rail, et le module 50 étant dimensionné pour que le fond 61 du boîtier 60 présente une forme complémentaire à la forme du rail 10, au niveau d'au moins un emplacement 11, lorsque l'embase 20 comporte des premières cavités 25 et des troisièmes cavités 27 configurées pour recevoir, chacune, un organe de retenue 617 du fond 61 du boîtier 60, le module 50 peut être positionné, avant son verrouillage, dans le mauvais sens dans son emplacement 11.

Lorsqu'un module 50 est inséré dans le bon sens dans un emplacement 11 du rail, le plot d'orientation 618 du module coopère avec le trou de réception 32 associé de l'embase 20.

Lorsqu'un module 50 est inséré dans le mauvais sens dans un emplacement 11 du rail 10, le plot d'orientation 318 du module 50 ne coopère avec aucun trou de réception 32 de l'embase 20, et permet avantageusement d'éviter le contact entre une rangée de connecteurs males 80 de la carte électronique 80 du module 50 et une rangée de connecteurs femelle 42 du bus fond de panier 40 et de créer un potentiel court-circuit, si le bus fond de panier 40 est alimenté.

Dans un mode de réalisation, pour assembler deux rails 10, l'ensemble 100 comporte un raccord d'union 90, 91.

Dans un exemple de réalisation, le raccord d'union est un raccord d'union droite 90. Un tel raccord d'union droite 90 permet avantageusement d'assembler mécaniquement et électriquement deux rails 10 bout à bout, c'est à dire longitudinalement, en liant les extrémités longitudinales 29 de l'embase 20. Les axes X de chaque rail 10 sont alors confondus.

Le raccord d'union droite 90 se présente sous la forme d'une pièce droite qui présente, à chacune de ses extrémités, une forme complémentaire à la forme de l'extrémité longitudinale 29 de l'embase 20 d'un rail. La pièce droite est préférentiellement apte à être emboitée, par clipsage, dans le renflement 28 de l'embase 20 de chacun des deux rails 10 à assembler.

Ledit raccord d'union droite comporte une carte électronique dite de liaison disposée dans la pièce droite. La carte électronique de liaison comporte à chaque extrémité du raccord d'union droite, un connecteur d'extrémité configuré pour coopérer avec un connecteur d'extrémité 46 du bus fond de panier 40 d'un rail.

Dans un autre exemple de réalisation, le raccord d'union est un raccord d'union en forme de U 91. Un tel raccord d'union permet avantageusement d'assembler mécaniquement et électriquement deux rails accolés longitudinalement, c'est à dire parallèles. Ledit raccord d'union 91 se présente sous la forme d'une pièce, en forme de U, qui présente à chacune de ses extrémités, une forme complémentaire à la forme de l'extrémité longitudinale 29 de l'embase 20 d'un rail. Ladite pièce est préférentiellement apte à être emboitée, par clipsage, dans le renflement 28 de l'embase 20 de chacun des deux rails à assembler. Ledit raccord d'union 91 comporte une carte électronique dite de liaison disposée dans la pièce en forme de U. La carte électronique comporte à chaque extrémité dudit raccord d'union 91, un connecteur d'extrémité configuré pour coopérer avec un connecteur d'extrémité 46 du bus fond de panier 40 d'un rail.

### Exemple d'assemblage d'un module 50

Dans une première étape, la carte électronique 80 est disposée dans le fond 61 du boîtier 60, positionnée sur les surfaces d'appuis 644 des épaulements 643 du fond 61.

Lorsque les épaulements 643 du fond 61 sont pourvus d'un picot 645, chaque picot 645 est inséré dans les orifices 84 traversants ménagés dans l'épaisseur de la carte électronique 80.

Dans une deuxième étape, le levier 70 de l'organe de verrouillage est monté sur le fond 61.

Le levier 70 de l'organe de verrouillage est positionné vis-à-vis du fond 61 de sorte que l'excroissance radiale 743 de chaque pion de montage 742 du levier 70 vient en regard de l'empreinte 616 complémentaire de l'orifice 615 associé du fond 61, puis introduit légèrement en force dans lesdits orifices dudit fond.

L'ordre de mise en œuvre de ces deux étapes n'est pas imposé et peuvent être réalisées dans l'ordre inverse décrit sans modifier le résultat desdites étapes.

Dans une étape finale, le couvercle 62 est assemblé au fond 61 par clipsage. Une rotation du levier 70 de l'organe de verrouillage autour de son axe de rotation X1 est nécessaire pour dégager l'accès au fond 61 et permettre l'assemblage du couvercle 62 et du fond 61.

Lorsque le couvercle 62 et le fond 61 sont assemblés, la carte électronique 80 est prise en sandwich entre les surfaces d'appui 642 des épaulements 641 dudit couvercle 62 et les surfaces d'appuis 644 des épaulements 643 dudit fond 61.

### Exemple de montage d'un module simple 50a, qu'il soit horizontal ou vertical, sur un rail 10

Le module simple 50a est dimensionné pour être monté dans un emplacement 11 du rail. Le module simple 50a comporte préférentiellement un organe de retenue 617. Le module simple 50a comporte préférentiellement un plot d'orientation 618. Le module simple 50a peut comporter une ou deux broches de connexion sur sa carte électronique 80.

Dans une première étape, le module simple 50a est positionné dans le rail 10.

Le levier 70 de l'organe de verrouillage du module simple 50a est placé dans une position déverrouillée. Puis, le module simple 50a est positionné sur le rail 10 par insertion de l'organe de retenue 617 du fond 61 du boîtier 60 dans la première cavité 25 de l'emplacement 11 choisi sur le rail 10. Le plot d'orientation 618 du module 50 coopère avec le trou de réception 32 associé de l'embase 20.

Une fois le module simple 50a positionné, le fond 61, et plus particulièrement la face interne 613 du fond 61, est en vis-à-vis de l'embase 20 du rail 10. La face interne 613 du fond 61 est disposée contre le plan de réception formé face supérieure 41 du bus fond de panier 40 et la face supérieure 211 de l'âme 21. Le plot d'orientation 618 du module coopère avec le trou de réception 32 de l'embase, au niveau de l'emplacement.

Dans une deuxième étape, le module 50a est verrouillé au rail. Le levier 70 de l'organe de verrouillage du module simple 50a est actionné, par une rotation autour de son axe de rotation X1, jusqu'à la position verrouillée. Chaque crochet 75 du levier de verrouillage est engagé respectivement dans une deuxième cavité 26 de l'embase, au niveau de l'emplacement 11. Le contact entre le module 50 et le bus fond de panier 40 est établi, via le contact entre la rangée de connecteurs males 81 d'une broche de connexion de la carte électronique 80 du module 50 et la rangée de connecteurs femelles 42 du bus fond de panier 40. Lorsque la carte électronique comporte deux broches de connexion comportant chacune une rangée de connecteurs males 81, chaque rangée de connecteurs males est en contact avec une rangée de connecteurs femelles du bus fond de panier 40.

Le module simple 50a est alors en position opérante et maintenu fixement au rail 10. Le module simple 50a est maintenu fixement au rail, comme illustré sur la figure 16, d'une part via l'organe de retenue 617 et d'autre part par les crochets 75 du levier 70.

Le module simple 50a est facilement monté sur le rail, et verrouillé audit rail, sans recourir à un outil particulier.

Un autre module 50 peut être ensuite monté sur le rail, dans un emplacement attenant à celui recevant le premier module ou à un emplacement distant.

### Exemple de montage d'un module double 50b, qu'il soit horizontal ou vertical, sur un rail 10

Le module double 50b est dimensionné pour être monté dans deux emplacements 11 attenants du rail, dit premier et deuxième emplacement. Le module double 50b peut comporter un ou deux organes de retenue, préférentiellement deux organes de retenue 617. Le module double 50b peut comporter un ou deux plots d'orientation 618, préférentiellement deux plots d'orientation. Le module double 50b peut comporter une ou deux broches de connexion sur sa carte électronique 80.

Dans une première étape, le module double 50b est positionné dans le rail 10.

Le levier 70 de l'organe de verrouillage du module double 50b est placé dans une position déverrouillée. Puis, le module double 50b est positionné sur le rail 10 par insertion d'un organe de retenue 617 du fond 61 du boîtier 60 dans la première cavité 25 d'un des deux emplacements 11 choisis sur le rail 10. Lorsque le module double 50b comporte deux organes de retenue, un organe de retenue est inséré dans la première cavité de l'embase, au niveau du premier emplacement, et l'autre organe de retenue est inséré dans la première cavité de l'embase, au niveau du deuxième emplacement.

Une fois le module double 50b positionné, le fond 61, et plus particulièrement la face interne 613 du fond 61, est en vis-à-vis de l'embase 20 du rail 10. La face interne 613 du fond 61 est disposée contre le plan de réception formé face supérieure 41 du bus fond de panier 40 et la face supérieure 211 de l'âme 21. Le plot d'orientation 618 du module 50 coopère avec le trou de réception 32 associé de l'embase 20 d'un emplacement. Lorsque le module double 50b comporte deux plots d'orientation, un plot d'orientation coopère respectivement avec le trou de réception de l'embase, au niveau du premier emplacement, et l'autre plot d'orientation coopère respectivement avec le trou de réception de l'embase, au niveau du deuxième emplacement.

Dans une deuxième étape, le module 50a est verrouillé au rail. Le levier 70 de l'organe de verrouillage du module double 50b est actionné, par une rotation autour de son axe de rotation X1, jusqu'à la position verrouillée. Un des crochets 75 du levier de verrouillage est engagé dans une deuxième cavité 26 de l'embase, au niveau du premier emplacement 11. L'autre crochet 75 du levier de verrouillage est engagé dans une deuxième cavité de l'embase, au niveau du deuxième emplacement. Le contact entre le module 50 et le bus fond de panier 40 est établi, via le contact entre la rangée de connecteurs males 81 d'une broche de connexion de la carte électronique 80 du module 50 et la rangée de connecteurs femelles 42 du bus fond de panier 40. Lorsque la carte électronique comporte deux broches de connexion comportant chacune une rangée de connecteurs males 81, une rangée de connecteurs males est en contact avec une rangée de connecteurs femelles du bus fond de panier 40, au niveau du premier emplacement, et l'autre rangée de connecteurs males est en contact avec une rangée de connecteurs femelles du bus fond de panier 40, au niveau du deuxième emplacement.

Le module double 50b est alors en position opérante et maintenu fixement au rail 10. Le module double 50b est maintenu fixement au rail, comme illustré sur la figure 16, d'une part via l'organe de retenue 617 et d'autre part par les crochets 75 du levier 70.

Le module double 50b est facilement monté sur le rail, et verrouillé audit rail, sans recourir à un outil particulier.

Un autre module 50 peut être ensuite monté sur le rail, dans un emplacement attenant à celui recevant le premier module ou à un emplacement distant.

### Exemple de montage d'un module triple 50c, qu'il soit horizontal ou vertical, sur un rail 10

Le module triple 50c est dimensionné pour être monté dans trois emplacements 11 attenants du rail, dit premier, deuxième et troisième emplacement. Le module triple 50c peut comporter un, deux ou trois organes de retenue, préférentiellement deux organes de retenue 617. Le module triple 50c peut comporter un, deux ou trois plots d'orientation 618, préférentiellement un plot d'orientation. Le module triple 50c peut comporter une ou deux broches de connexion sur sa carte électronique 80.

Dans une première étape, le module triple 50c est positionné dans le rail 10.

Le levier 70 de l'organe de verrouillage du module triple 50c est placé dans une position déverrouillée. Puis, le module triple 50c est positionné sur le rail 10 par insertion d'un organe de retenue 617 du fond 61 du boîtier 60 dans la première cavité 25 d'un des trois emplacements 11 choisis sur le rail 10. Lorsque le module triple 50c comporte deux organes de retenue, un organe de retenue est inséré dans la première cavité de l'embase, au niveau du premier emplacement, et l'autre organe de retenue est inséré dans la première cavité de l'embase, au niveau du troisième emplacement. Lorsque le module triple 50c comporte trois organes de retenue, un organe de retenue est inséré dans la première cavité de l'embase, au niveau du premier emplacement, un autre organe de retenue est inséré dans la première cavité de l'embase, au niveau du deuxième emplacement et le dernier organe de retenue est inséré dans la première cavité de l'embase, au niveau du troisième emplacement.

Une fois le module triple 50c positionné, le fond 61, et plus particulièrement la face interne 613 du fond 61, est en vis-à-vis de l'embase 20 du rail 10. La face interne 613 du fond 61 est disposée contre le plan de réception formé face supérieure 41 du bus fond de panier 40 et la face supérieure 211 de l'âme 21. Le plot d'orientation 618 du module 50 coopère avec le trou de réception 32 associé de l'embase 20 d'un emplacement. Lorsque le module triple 50c comporte deux plots d'orientation, un plot d'orientation coopère respectivement avec le trou de réception de l'embase, au niveau d'un des trois emplacements, et l'autre plot d'orientation coopère respectivement avec le trou de réception de l'embase, au niveau d'un autre emplacement parmi les deux emplacements restants.

Dans une deuxième étape, le module 50a est verrouillé au rail. Le levier 70 de l'organe de verrouillage du module triple 50c est actionné, par une rotation autour de son axe de rotation X1, jusqu'à la position verrouillée. Un des crochets 75 du levier de verrouillage est engagé dans une deuxième cavité 26 de l'embase, au niveau du premier emplacement. L'autre crochet 75 du levier de verrouillage est engagé dans une deuxième cavité de l'embase, au niveau du troisième emplacement. Le contact entre le module 50 et le bus fond de panier 40 est établi, via le contact entre la rangée de connecteurs males 81 d'une broche de connexion de la carte électronique 80 du module 50 et la rangée de connecteurs femelles 42 du bus fond de panier 40. Lorsque la carte électronique comporte deux broches de connexion comportant chacune une rangée de connecteurs males 81, une rangée de connecteurs males est en contact avec une rangée de connecteurs femelles du bus fond de panier 40, au niveau du premier emplacement, et l'autre rangée de connecteurs males est en contact avec une rangée de connecteurs femelles du bus fond de panier 40, au niveau du troisième emplacement.

Le module triple 50c est alors en position opérante et maintenu fixement au rail 10. Le module triple 50c est maintenu fixement au rail, comme illustré sur la figure 16, d'une part via l'organe de retenue 617 et d'autre part par les crochets 75 du levier 70.

Le module triple 50c est facilement monté sur le rail, et verrouillé audit rail, sans recourir à un outil particulier.

Un autre module 50 peut être ensuite monté sur le rail, dans un emplacement attenant à celui recevant le premier module ou à un emplacement distant.

### Exemple de montage d'un module bi-rail 50', simple, qu'il soit horizontal ou vertical, sur deux rails 10 accolés longitudinalement.

Les deux rails sont dits premier rail et deuxième rail. Le module bi-rail simple 50' est dimensionné pour être monté dans un emplacement 11 de chaque rail, dit premier et deuxième emplacement. Le premier emplacement est sur le premier rail et le deuxième emplacement est sur le deuxième rail.

Le module bi-rail simple 50' comporte un organe de retenue. Le module bi-rail simple 50' comporte un plot d'orientation 618. Le module bi-rail simple 50' peut comporter une ou deux broches de connexion sur sa carte électronique 80.

Dans une première étape, le module bi-rail simple 50' est positionné dans les deux rails 10.

Le levier 70 de l'organe de verrouillage du module bi-rail simple 50' est placé dans une position déverrouillée. Puis, le module bi-rail simple 50' est positionné sur les deux rails 10 par insertion de l'organe de retenue 617 du fond 61 du boîtier 60 dans la première cavité 25 du deuxième emplacement 11 sur le deuxième rail 10.

Une fois le module bi-rail simple 50' positionné, le fond 61, et plus particulièrement la face interne 613 du fond 61, est en vis-à-vis de l'embase 20 de chaque rail 10. Le plot d'orientation 618 du module bi-rail simple 50' coopère avec le trou de réception 32 associé de l'embase 20 du premier emplacement ou du deuxième emplacement.

Dans une deuxième étape, le module bi-rail est verrouillé au rail. Le levier 70 de l'organe de verrouillage du module bi-rail est actionné, par une rotation autour de son axe de rotation X1, jusqu'à la position verrouillée. Un des crochets 75 du levier de verrouillage est engagé dans une deuxième cavité 26 de l'embase, au niveau du premier emplacement 11. L'autre crochet 75 du levier de verrouillage est engagé dans l'autre deuxième cavité de l'embase, au niveau du premier emplacement du premier rail. Le contact entre le module 50 et le bus fond de panier 40 est établi, via le contact entre la rangée de connecteurs males 81 d'une broche de connexion de la carte électronique 80 du module 50 et la rangée de connecteurs femelles 42 du bus fond de panier 40. Lorsque la carte électronique comporte deux broches de connexion comportant chacune une rangée de connecteurs males 81 :
- une rangée de connecteurs males est en contact avec une rangée de connecteurs femelles du bus fond de panier 40, au niveau du premier emplacement, et l'autre rangée de connecteurs males est en contact avec une rangée de connecteurs femelles du bus fond de panier 40, au niveau du deuxième emplacement, ou
- chaque rangée de connecteurs males est en contact avec une rangée de connecteurs femelles du bus fond de panier 40, au niveau du premier ou du deuxième emplacement.

Le module bi-rail simple 50' est alors en position opérante et maintenu fixement au rail 10. Le module bi-rail simple 50' est maintenu fixement au rail, comme illustré sur la figure 16, d'une part via l'organe de retenue 617 et d'autre part par les crochets 75 du levier 70.

Le module bi-rail simple 50' est facilement monté sur le rail, et verrouillé audit rail, sans recourir à un outil particulier.

Un module bi-rail double ou triple est monté de manière similaire au module mono-rail double ou triple, mais agencé sur deux rails parallèles.

## Revendications

1. Ensemble électronique modulaire (1) comportant :
- un rail (10) comportant une embase (20), allongée selon un axe X, logeant une carte électronique dite bus fond de panier (40), allongée selon l'axe X, ledit rail définissant une pluralité d'emplacements (11) alignés selon ledit axe X,
l'embase (20) comportant, au niveau de chaque emplacement (11), d'une part une première cavité (25) et d'autre part deux deuxièmes cavités (26), le bus fond de panier (40) comportant, au niveau de chaque emplacement (11), une rangée de connecteurs femelles (42),
- une pluralité de modules électronique (50), dit modules,
chaque module (50) étant configuré pour être monté dans au moins un emplacement (11) du rail (10) et à y être maintenu fixement de manière réversible dans une position dite opérante, chaque module (50) comportant :
∘ un boîtier (60) comportant un fond (61) et un couvercle (62), le fond (61) comportant au moins un organe de retenue (617) saillant vers l'extérieur dudit boîtier,
∘ une carte électronique (80) logée dans le boîtier (60), comportant au moins une broche de connexion formée d'une rangée de connecteurs males (81) qui s'étendent hors du boîtier (60) via une fenêtre traversante (619) pratiquée dans le fond (61) du boîtier (60),
∘ un organe de verrouillage (7) comportant un levier (70) monté libre en rotation par rapport au fond (61), ledit levier comportant, au niveau d'une partie proximale (71), deux crochets (75),
l'ensemble électronique modulaire (1) étant tel que :
- lorsqu'un module (50) est monté dans un emplacement (11) du rail (10) et fixé de position opérante :
∘ le fond (61) dudit module est positionné en vis-à-vis du rail (10),
∘ un organe de retenue (617) du fond (61) dudit module est engagé dans la première cavité (25) de l'embase (20),
∘ chaque crochet (75) du levier (70) de l'organe de verrouillage dudit module est engagé respectivement dans une deuxième cavité (26) de l'embase (20),
∘ la rangée de connecteurs males (81) d'une broche de connexion de la carte électronique (80) dudit module est en contact avec la rangée de connecteurs femelles (42), ou
- lorsqu'un module (50) est monté dans au moins deux emplacements (11) attenants du rail (10) et fixé dans une position opérante :
∘ le fond (61) dudit module est positionné en vis-à-vis du rail (10),
∘ un organe de retenue (617) du fond (61) dudit module est engagé dans la première cavité (25) de l'embase (20) au niveau d'un des au moins deux emplacements,
∘ un des crochets (75) du levier (70) de l'organe de verrouillage dudit module est engagé dans une deuxième cavité (26) de l'embase (20) au niveau d'un des au moins deux emplacements, et l'autre crochet est engagé dans une deuxième cavité (26) de l'embase (20) au niveau d'un autre des au moins deux emplacements,
∘ la rangée de connecteurs males (81) d'une broche de connexion de la carte électronique (80) dudit module est en contact avec une rangée de connecteurs femelles (42), au niveau d'un des au moins deux emplacements.

2. Ensemble électronique modulaire (1) selon la revendication 1 dans lequel chaque deuxième cavité (26) est :
- agencée à cheval sur deux emplacements (11) voisins attenants du rail (10),
- dimensionnée pour recevoir deux crochets (75) de deux modules (50) disposés chacun dans un desdits deux emplacements.

3. Ensemble électronique modulaire (1) selon l'une des revendications précédentes, dans lequel :
- au niveau de chaque emplacement (11) du rail (10), l'embase (20) comporte un trou de réception (32),
- le fond (61) du boîtier (60) d'un module (50) comporte un plot d'orientation (618),
l'ensemble électronique modulaire (1) étant tel que lorsque le module (50) est monté dans au moins un emplacement (11) du rail (10) et fixé dans une position opérante, le plot d'orientation (618) coopère avec un trou de réception (32) de l'embase, au niveau d'un emplacement du rail (10).

4. Ensemble électronique modulaire (1) selon l'une des revendications précédentes dans lequel le boîtier (60) d'un module (60) comporte des éléments de maintien en position (641, 642, 643, 644, 645) de la carte électronique (80) dans le boîtier (60).

5. Ensemble électronique modulaire (1) selon l'une des revendications précédentes dans lequel le boîtier (60) d'un module (50) comporte une ouverture traversante (66) pratiquée dans le couvercle (62) pour le passage d'un connecteur secondaire (83) disposé sur la carte électronique (80) du module (50).

6. Ensemble électronique modulaire (1) selon l'une des revendications précédentes dans lequel le rail (10) comporte des éléments de clipsage (14) destinés à coopérer avec des éléments de clipsage (14) d'un autre rail.

7. Ensemble électronique modulaire (1) selon l'une des revendications précédentes comportant deux rails (10) et un raccord d'union (90, 91) pour assembler mécaniquement et électriquement lesdits deux rails.

8. Ensemble électronique modulaire (1) selon l'une des revendications précédentes comportant deux rails (10) et un module électronique bi-rail (50'), ledit module électronique bi-rail (50') étant configuré pour, lorsque les deux rails (10) sont accolés longitudinalement, être monté dans au moins un emplacement (11) de chaque rail (10) et à y être maintenu fixement de manière réversible dans une position opérante.

9. Rail (10) pour ensemble électronique modulaire (1) selon l'une des revendications 1 à 8.

10. Module électronique (50) pour ensemble électronique modulaire (1) selon l'une des revendications 1 à 8.

## Patentansprüche

1. Modulare elektronische Anordnung (1), umfassend:
- eine Schiene (10), die einen Sockel (20) umfasst, der sich entlang einer X-Achse erstreckt, eine als Rückwandbus (40) bezeichnete Leiterplatte beherbergend, die sich entlang der X-Achse erstreckt, wobei die Schiene eine Vielzahl von Steckplätzen (11) definiert, die entlang der X-Achse ausgerichtet sind, wobei der Sockel (20) an jedem Steckplatz (11) einerseits einen ersten Hohlraum (25) und andererseits zwei zweite Hohlräume (26) umfasst, wobei der Rückwandbus (40) an jedem Steckplatz (11) eine Reihe von weiblichen Verbindern (42) umfasst,
- eine Vielzahl von als Module bezeichneten elektronischen Modulen (50), wobei jedes Modul (50) so konfiguriert ist, dass es in mindestens einem Steckplatz (11) der Schiene (10) montiert und dort reversibel in einer sogenannten Betriebsposition festgehalten werden kann, wobei jedes Modul (50) umfasst:
∘ ein Gehäuse (60), das einen Boden (61) und einen Deckel (62) umfasst, wobei der Boden (61) mindestens ein Halteglied (617) umfasst, das zur Außenseite des Gehäuses vorspringt,
∘ eine in dem Gehäuse (60) beherbergte Leiterplatte (80), die mindestens einen Verbindungsstift umfasst, der von einer Reihe von männlichen Verbindern (81) gebildet wird, die sich über ein Durchgangsfenster (619), das im Boden (61) des Gehäuses (60) ausgestaltet ist, aus dem Gehäuse (60) erstrecken,
∘ ein Verriegelungsglied (7), das einen Hebel (70) umfasst, der in Bezug auf den Boden (61) frei drehbar montiert ist, wobei der Hebel an einem proximalen Teil (71) zwei Haken (75) umfasst,
wobei die modulare elektronische Anordnung (1) derart beschaffen ist, dass:
- wenn ein Modul (50) in einem Steckplatz (11) der Schiene (10) montiert und in Betriebsposition befestigt wird:
∘ der Boden (61) des Moduls der Schiene (10) zugewandt positioniert wird,
∘ ein Halteglied (617) des Bodens (61) des Moduls in den ersten Hohlraum (25) des Sockels (20) eingerückt wird,
∘ jeder Haken (75) des Hebels (70) des Verriegelungsgliedes des Moduls jeweils in einen zweiten Hohlraum (26) des Sockels (20) eingerückt wird,
∘ die Reihe von männlichen Verbindern (81) eines Verbindungsstiftes der Leiterplatte (80) des Moduls mit der Reihe von weiblichen Verbindern (42) in Kontakt steht, oder
- wenn ein Modul (50) in mindestens zwei aneinandergrenzenden Steckplätzen (11) der Schiene (10) montiert und in einer Betriebsposition befestigt wird:
∘ der Boden (61) des Moduls der Schiene (10) zugewandt positioniert wird,
∘ ein Halteglied (617) des Bodens (61) des Moduls an einem der mindestens zwei Steckplätze in den ersten Hohlraum (25) des Sockels (20) eingerückt wird,
∘ einer der Haken (75) des Hebels (70) des Verriegelungsgliedes des Moduls an einem der mindestens zwei Steckplätze in einen zweiten Hohlraum (26) des Sockels (20) eingerückt wird und der andere Haken an einem anderen der mindestens zwei Steckplätze in einen zweiten Hohlraum (26) des Sockels (20) eingerückt wird,
∘ die Reihe von männlichen Verbindern (81) eines Verbindungsstiftes der Leiterplatte (80) des Moduls an einem der mindestens zwei Steckplätze mit einer Reihe von weiblichen Verbindern (42) in Kontakt steht.

2. Modulare elektronische Anordnung (1) nach Anspruch 1, wobei jeder zweite Hohlraum (26):
- rittlings auf zwei benachbarten aneinandergrenzenden Steckplätzen (11) der Schiene (10) angeordnet ist,
- so bemessen ist, dass er zwei Haken (75) von zwei Modulen (50), die jeweils in einem der zwei Steckplätze angeordnet sind, aufnimmt.

3. Modulare elektronische Anordnung (1) nach einem der vorstehenden Ansprüche, wobei:
- der Sockel (20) an jedem Steckplatz (11) der Schiene (10) ein Aufnahmeloch (32) umfasst,
- der Boden (61) des Gehäuses (60) eines Moduls (50) einen Ausrichtungszapfen (618) umfasst,
wobei die modulare elektronische Anordnung (1) derart beschaffen ist, dass, wenn das Modul (50) in mindestens einem Steckplatz (11) der Schiene (10) montiert und in einer Betriebsposition befestigt wird, der Ausrichtungszapfen (618) an einem Steckplatz der Schiene (10) mit einem Aufnahmeloch (32) des Sockels zusammenwirkt.

4. Modulare elektronische Anordnung (1) nach einem der vorstehenden Ansprüche, wobei das Gehäuse (60) eines Moduls (60) Positionshalteelemente (641, 642, 643, 644, 645) für die Leiterplatte (80) im Gehäuse (60) umfasst.

5. Modulare elektronische Anordnung (1) nach einem der vorstehenden Ansprüche, wobei das Gehäuse (60) eines Moduls (50) eine Durchgangsöffnung (66) umfasst, die im Deckel (62) für die Durchführung eines sekundären Verbinders (83), der auf der Leiterplatte (80) des Moduls (50) angeordnet ist, ausgestaltet ist.

6. Modulare elektronische Anordnung (1) nach einem der vorstehenden Ansprüche, wobei die Schiene (10) Clipelemente (14) umfasst, die dazu bestimmt sind, mit Clipelementen (14) einer anderen Schiene zusammenzuwirken.

7. Modulare elektronische Anordnung (1) nach einem der vorstehenden Ansprüche, die zwei Schienen (10) und einen Fügeanschluss (90,91) umfasst, um die zwei Schienen mechanisch und elektrisch zusammenzubauen.

8. Modulare elektronische Anordnung (1) nach einem der vorstehenden Ansprüche, die zwei Schienen (10) und ein elektronisches Doppelschienenmodul (50') umfasst, wobei das elektronische Doppelschienenmodul (50') so konfiguriert ist, dass es, wenn die zwei Schienen (10) in Längsrichtung aneinandergefügt werden, in mindestens einem Steckplatz (11) jeder Schiene (10) montiert und dort reversibel in einer Betriebsposition festgehalten werden kann.

9. Schiene (10) für eine modulare elektronische Anordnung (1) nach einem der Ansprüche 1 bis 8.

10. Elektronisches Modul (50) für eine modulare elektronische Anordnung (1) nach einem der Ansprüche 1 bis 8.

## Claims

1. Modular electronic assembly (1), comprising:
- a rail (10) comprising a base (20), elongated according to an axis X, accommodating an electronic board referred to as a backplane bus (40), elongated according to the axis X, said rail defining a plurality of slots (11) aligned according to said axis X,
the base (20) comprising, at each slot (11), on the one hand a first cavity (25) and, on the other hand, two second cavities (26),
the backplane bus (40) comprising, at each slot (11), a row of female connectors (42),
- a plurality of electronic modules (50), called modules,
- each module (50) being configured to be mounted in at least one slot (11) of the rail (10) and to be fixedly and reversibly held therein in a so-called operative position, each module (50) comprising:
∘ a case (60) comprising a bottom (61) and a cap (62), the bottom (61) comprising at least one retaining member (617) projecting outwardly of said case,
∘ an electronic board (80) accommodated in the case (60), comprising at least one connection pin formed by a row of male connectors (81) which extend out of the case (60) via a through aperture (619) formed in the bottom (61) of the case (60),
∘ a locking member (7) comprising a lever (70) mounted free to rotate relative to the bottom (61), said lever comprising two hooks (75) at a proximal portion (71),
the modular electronic assembly (1) being such that:
- when a module (50) is mounted in a slot (11) of the rail (10) and fixed in the operative position:
∘ the bottom (61) of said module is positioned opposite the rail (10),
∘ a retaining member (617) of the bottom (61) of said module is engaged in the first cavity (25) of the base (20),
∘ each hook (75) of the lever (70) of the locking member of said module is engaged respectively in a second cavity (26) of the base (20),
∘ the row of male connectors (81) of a connection pin of the electronic board (80) of said module is in contact with the row of female connectors (42), or
- when a module (50) is mounted in at least two adjacent slots (11) of the rail (10) and fixed in an operative position:
∘ the bottom (61) of said module is positioned opposite the rail (10),
∘ a retaining member (617) of the bottom (61) of said module is engaged in the first cavity (25) of the base (20) at one of the at least two slots,
∘ one of the hooks (75) of the lever (70) of the locking member of said module is engaged in a second cavity (26) of the base (20) at one of the at least two slots, and the other hook is engaged in a second cavity (26) of the base (20) at another one of the at least two slots,
∘ the row of male connectors (81) of a connection pin of the electronic board (80) of said module is in contact with a row of female connectors (42), at one of the at least two slots.

2. Modular electronic assembly (1) of claim 1, wherein each second cavity (26) is:
- arranged astride two adjacent neighbouring slots (11) of the rail (10),
- dimensioned so as to receive two hooks (75) of two modules (50) each arranged in one of said two slots.

3. Modular electronic assembly (1) according to one of the preceding claims, wherein:
- at each slot (11) of the rail (10), the base (20) comprises a receiving hole (32),
- the bottom (61) of the case (60) of a module (50) comprises an orientation lug (618),
the modular electronic assembly (1) being such that when the module (50) is mounted in at least one slot (11) of the rail (10) and fixed in an operative position, the orientation lug (618) cooperates with a receiving hole (32) of the base, at a slot of the rail (10).

4. Modular electronic assembly (1) according to one of the preceding claims, wherein the case (60) of a module (60) comprises elements (641, 642, 643, 644, 645) for holding the electronic board (80) in position in the case (60).

5. Modular electronic assembly (1) according to one of the preceding claims, wherein the case (60) of a module (50) comprises a through opening (66) formed in the cap (62) for the passage of a secondary connector (83) arranged on the electronic board (80) of the module (50).

6. Modular electronic assembly (1) according to one of the preceding claims, wherein the rail (10) comprises clipping elements (14) intended to cooperate with clipping elements (14) of another rail.

7. Modular electronic assembly (1) according to one of the preceding claims, comprising two rails (10) and a union connector (90, 91) for mechanically and electrically assembling said two rails.

8. Modular electronic assembly (1) according to one of the preceding claims, comprising two rails (10) and a dual-rail electronic module (50'), said dual-rail electronic module (50') being configured, when the two rails (10) are longitudinally attached, to be mounted in at least one slot (11) of each rail (10) and to be fixedly and reversibly held therein in an operative position.

9. Rail (10) for a modular electronic assembly (1) according to one of claims 1 to 8.

10. Electronic module (50) for a modular electronic assembly (1) according to one of claims 1 to 8.
